# EUROPEAN PATENT APPLICATION

(11) **EP 1 059 584 A2**
(43) Date of publication of application: **13.12.2000**
(21) Application number: 00111717.5
(22) Date of filing: 31.05.2000
(51) Int. Cl.: G06F 11/263, G01R 31/3183

(54) **Method and apparatus for generating test pattern for circuit blocks**

(30) Priority: 02.06.1999 JP 15576499
(71) Applicant: NEC CORPORATION, Tokyo (JP)
(72) Inventor: Otsuka, Shigekazu, c/o NEC Corporation, Tokyo (JP)
(74) Representative: Betten & Resch

(57) **Abstract**

In a method for generating a test pattern for testing at least one circuit block (24-1, 24-2, 24-3) of a semiconductor device including a control circuit (21) connected to the circuit block the above-mentioned test pattern is generated by converting a common test pattern (11) for the circuit block with reference to a data conversion library (12) corresponding to characteristics of the control circuit.

## Description

### BACKGROUND OF THE INVENTION

### Field of the Invention

The present invention relates to a method and apparatus for generating a test pattern for testing circuit blocks (peripheral macros) of a semiconductor device such as a one-chip microcomputer.

### Description of the Related Art

Generally, a one-chip microcomputer is constructed by various kinds of peripheral macros such as a display control macro, a communication control macro and a timer macro in addition to a central processing unit and a memory. The peripheral macros have to be indispensably tested for operation along with the CPU and the memory in the process of manufacturing such a one-chip microcomputer.

Meanwhile, CPUs are manufactured in a plurality of series, and as a result, the number of bits and the instruction codes of the CPUs differ from series to series. Therefore, in a prior art method for testing the peripheral macros, different test patterns have to be supplied externally to one-chip microcomputers having CPUs of different series, even if the same peripheral macros are commonly used in the one-chip microcomputers. This requires a large number of new test patterns being generated. As a result, the load and time required for preparing such test patterns is enormous.

Note that a bus specifically designed for a peripheral macro test may be arranged within a one-chip microcomputer and connected to the macros of the one-chip microcomputer, however, such an arrangement gives rise to a problem of an increased number of test terminals and hence is not feasible.

### SUMMARY OF THE INVENTION

It is an object of the present invention to provide a method and apparatus for generating a test pattern for testing peripheral macros of a semiconductor device such as a one-chip microcomputer capable of reducing the load and line required for preparing such a test pattern.

According to the present invention, in a method for generating a test pattern for testing at least one circuit block of a semiconductor device including a control circuit connected to the circuit block the above-mentioned test pattern is generated by converting a common test pattern for the circuit block with reference a data conversion library corresponding to characteristics of the control circuit.

### BRIEF DESCRIPTION OF THE DRAWINGS

The present invention will be more clearly understood from the description set forth below, with reference to the accompanying drawings, wherein:
Fig. 1 is a block circuit diagram illustrating an embodiment of the test apparatus for testing semiconductor devices according to the present invention;
Fig. 2 is a detailed block circuit diagram of the one-chip microcomputer of Fig. 1;
Fig. 3 is a detailed block circuit diagram of the test circuit of Fig. 2;
Fig. 4 is a detailed circuit diagram of the bus bridge circuit of Fig. 2;
Fig. 5A is a table showing an example of the content of the macro common test pattern file of Fig. 1;
Fig. 5B is a table showing an example of the content of the CPU series conversion library of Fig. 1;
Fig. 5C is a table showing an example of the content of the product parameter file of Fig. 1; and
Figs. 6, 7 and 8 are block circuit diagrams illustrating modifications of the one-chip microcomputer of Fig. 2.

### DESCRIPTION OF THE PREFERRED EMBODIMENT

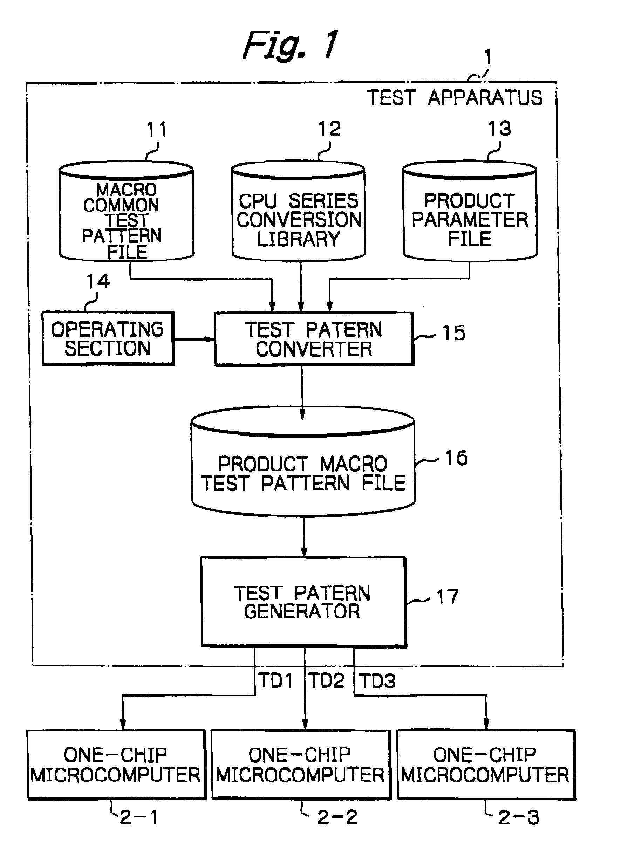

An embodiment of the test apparatus for testing semiconductor devices according to the present invention will now be explained with reference to Fig. 1.

In Fig. 1, reference numeral 1 designates a test apparatus for testing semiconductor devices such as one-chip microcomputers 2-1, 2-2 and 2-3.

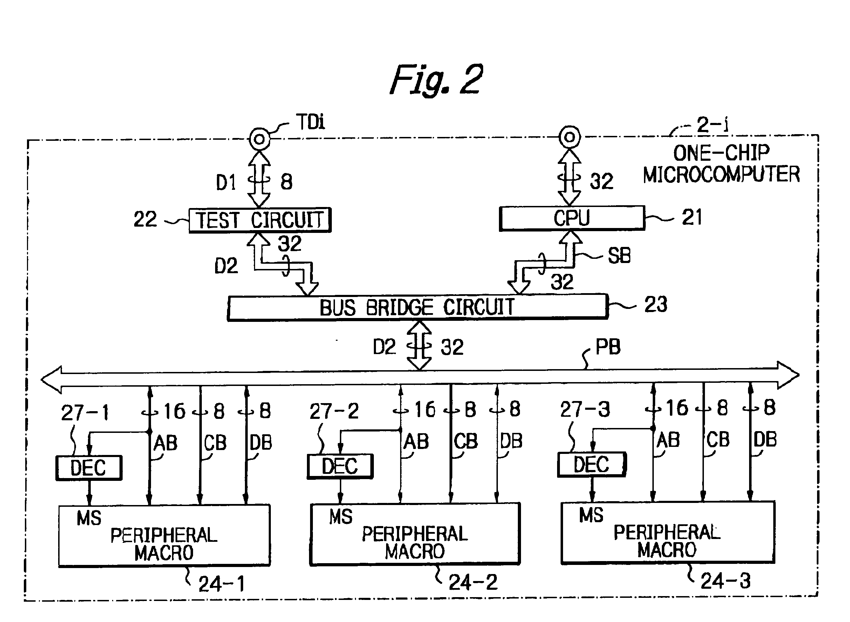

One of the one-chip microcomputers 2-1, 2-2 and 2-3 is illustrated in Fig. 2. In Fig. 2, reference numeral 21 designates a control processing unit (CPU), 22 designates a test circuit, and 23 designates a bus bridge circuit 24. The test circuit 22 tests circuit blocks (peripheral macros) 24-1, 24-2 ad 24-3 via the bus bridge circuit 23 without the CPU 21.

A high-speed system bus SB is connected between the CPU 21 and the bus bridge circuit 23, while a low-speed peripheral bus PB is connected between the bus bridge circuit 23 and the peripheral macros 24-1, 24-2 and 24-3. For example, the peripheral macro 24-1 is a macro for controlling the display, the peripheral macro 24-2 is a macro for controlling the communication, and the peripheral macro 24-3 is a timer macro.

The peripheral bus PB is constructed by an address bus AB, a control bus CB and a data bus DB. The macros 24-1, 24-2 and 24-3 are associated with decoders 27-1, 27-2 and 27-3, respectively, which are connected to the address bus AB. The decoders 27-1, 27-2 and 27-3 decode upper bits of the address bus AB and transmit their output signals to macro selection terminals MS of the peripheral macros 24-1, 24-2 and 24-3, thus operating the peripheral macros 24-1, 24-2 and 24-3, respectively.

In a test mode, the test circuit 22 converts a plurality of data D1 supplied to a test data terminal TDi into data D2 and transmits the data D2 to the bus bridge circuit 23. In addition, the bus bridge circuit 23 converts a plurality of data D2 into data D3 and transmits the data D3 to the macros 24-1, 24-2 and 24-3.

Here assume the number of bits of the data D1, D2 and D3, the address bus AB, the control bus CB and the data bus DB are as follows:
D1 8 bits
D2 32 bits
D3(AB, CB, DB) 32 bits
AB 16 bits
CB 8 bits
DB 8 bits

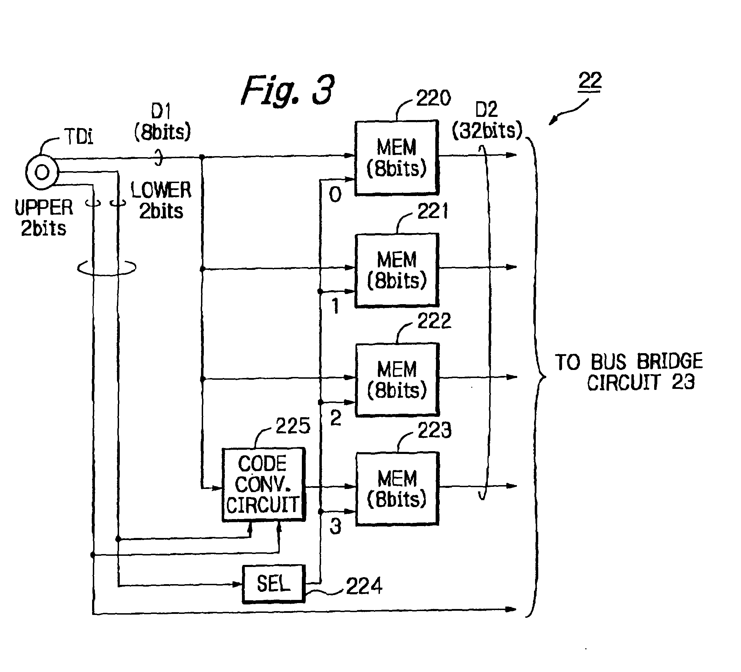

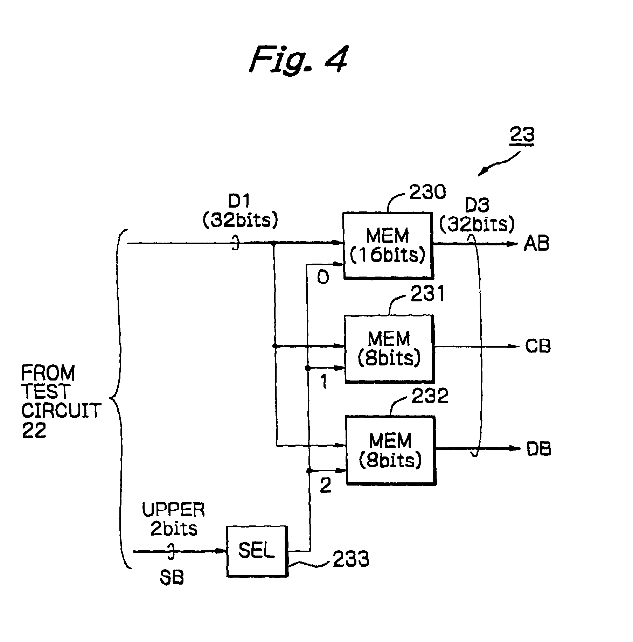

Note that the data D1 is associated with selection data SD (4bits) for operating selectors (not shown in Fig. 2, but in Figs. 3 and 4).

An example of the data D3 is given by three series of 32-bit data:
5500_{H} (AB), 0B_{H}(CB) and 06_{H}(DB) where "H" designates a hexadecimal notation, "5500_{H}" designates a macro number of the peripheral macro 24-1, and "0B" designates a write instruction.

In the above-mentioned state, the test circuit 22 has to generate three series of 32-bit data D2 corresponding to the three series of 32-bit data D3. That is,
FFFF5500_{H}, 0000000B_{H}, and 00000006_{H}.

Also, 12 series of 8-bit data D1 corresponding to the three series of 32-bit data D2 are supplied to the test data terminal TDi. That is,
FF_{H}, FF_{H}, 55_{H}, 00_{R}, 00_{R}, 00_{H}, 00_{H}, 0A_{H}, 00_{H}, 00_{H}, 00_{H} and 06_{H}
where "0A" designates a single write instruction. The single write instruction "0A" is converted by the test circuit 21 into the write instruction 0B_{H}. In this case, the data D1 is associated with the selection data SD. Therefore, the data D1 + SB can be represented by
FF0_{H}, FF1_{H}, 552_{H}, 003_{H}, 004_{R}, 005_{H}, 006_{H}, 007_{H}, 008_{H} 009_{H}, 00A_{H} and 06B_{H}.

When 12 series of 8-bit data D1 are prepared as a test pattern by the test apparatus 1 and are supplied to the test data terminal TDi, the 12 series of 8-bit data D1 are converted into 3 series of 32-bit data DZ by the test circuit 22 as illustrated in Fig. 3. In Fig. 3, four 8-bit memories 220, 221, 222 and 223, a selector 224, and a code conversion circuit 225 are provided. In this case, each 8-bit data D1 is formed by 8-bit data associated with 4-bit selection data SD. Therefore, the selector 224 selects one of the memories 220, 221, 222 and 223 in accordance with the lower 2 bits of the selection data SD, so that each 4-series of 8-bit data D1 (32 bits) are stored in the memories 220, 221, 222 and 223, which generate 32-bit data D2. Thus, the 12 series of 8-bit data D1 are converted into 3 series of 32-bit data D2.

In Fig. 3, the code conversion circuit 225 includes a conversion table for converting an instruction code on the test data terminal TDi into an instruction code on the peripheral bus PB, i.e., on the system bus SB. For example, when the selection data SD indicates a special value such as 11_{H}, the code conversion circuit 225 carries out a code conversion. Otherwise the code conversion circuit 225 is in a through state.

Also, the upper 2 bits of the selection data SD are transmitted directly to the bus bridge circuit 23.

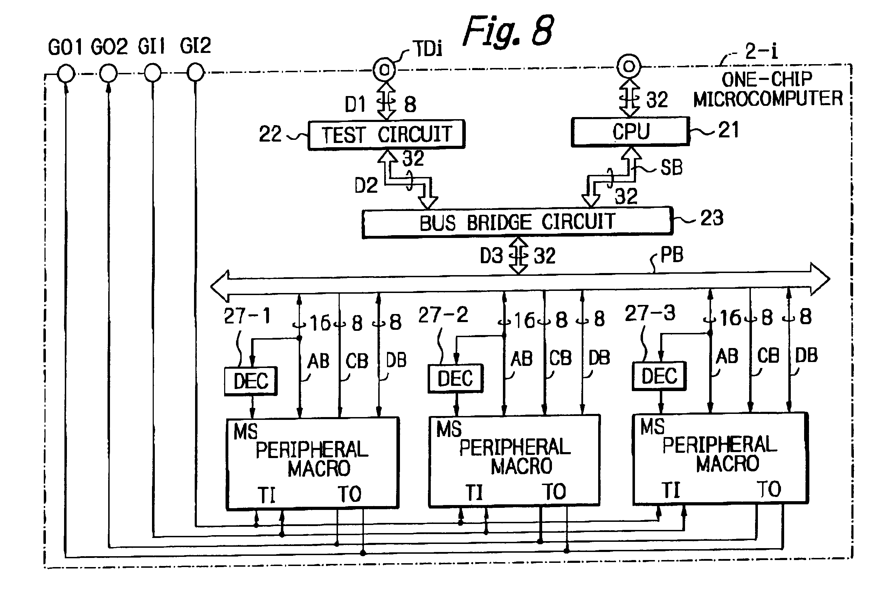

When 3 series of 32-bit data D2 are supplied to the bus bridge circuit 23, the 3 series of 32-bit data D2 are converted into one series of 32-bit data D3 by the bus bridge circuit 23 as illustrated in Fig. 4. In Fig. 4, 8-bit memories 231 and 232, a 16-bit memory 230 and a selector 233 are provided. In this case, each 32-bit data D2 is formed by 32-bit data associated with the upper 2 bits of the selection data SD. Therefore, the selector 233 selects one of the memories 230, 231 and 232 in accordance with the upper 2 bits of the selection data SD. As a result, the lower 16 bits of a first 32-bit data D2 are stored in the memory 230, the lower 8-bits of a second 32-bit data D2 are stored in the memory 231, and the lower 8-bits of a third 32-bit data D2 are stored in the memory 232. Thus, the 3 series of 32-bit data D2 are converted into the 32-bit data D3.

Note that the bus bridge circuit 23 passes signals from the CPU21 in a non-test mode; however, the configuration of the bus bridge circuit 23 for the CPU 21 is omitted to simplify the description.

As described above, in the case of a one-chip microcomputer of Fig. 2, it is necessary to supply the above 12 series of 8-bit data D1 associated with the 4-bit selection data SD to the test terminal TDi in order to supply the 32-bit test data D3 to the peripheral bus 0B.

Now, in the case of a one-chip microcomputer having the same peripheral macros 24-1, 24-2 and 24-3, if a CPU of a series different than that of the CPU 21 is used, a test circuit and a bus bridge circuit differ from their counterparts of Fig. 2. Therefore, test pattern data D1 to be supplied to the test data terminal TDi has to be different from the above described one. Additionally, if the series of a CPU is the same as that of the CPU of the above described one-chip microcomputer, this one-chip microcomputer may have a configuration different from that of the above described one and includes one or more than one additional circuits that are not illustrated in Fig. 2. If the number of bits of the test data terminal TDi is only 4, test pattern data to be supplied to the test data terminal TDi in order to supply the data D3 to the peripheral bus PB will be different from the above described test pattern data 1.

Thus, if the peripheral macros 24-1, 24-2 and 24-3 to be tested are not varied, the test pattern data D1 vary depending on the series of the CPU 21.

Additionally, the test pattern data D1 may vary depending on from product to product.

The test apparatus 1 of Fig. 1 is designed by taking the above-described dependency into consideration.

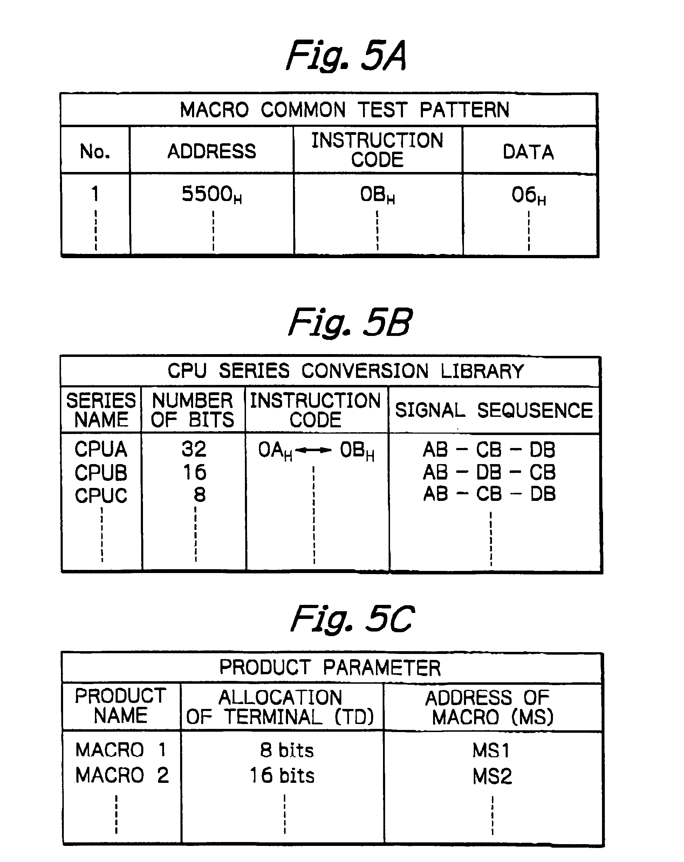

In Fig. 1, reference numeral 11 designates a macro common test pattern file where test patterns common to the macros are written. As shown in Fig. 5A, the macro common test patterns are defined simply by the macros to be tested and are not affected by the series of the CPU 21 and the difference among the external terminals of products, i.e., the test data terminals TDi of one-chip microcomputers.

Also, reference numeral 12 designates a CPU series conversion library where data to be used for converting the macro common test pattern to the macros depending on the CPU series. As shown in Fig. 5B, the CPU series typically vary in terms of:
number of bits (8 bits, 16 bits and 32 bits);
instruction codes; and
the sequence of data (address, control and data). The CPU series conversion library 12 stores the differences for the CPU series.

Further, reference numeral 13 designates a product parameter file for allocating a test data terminal TDi and a macro selection address MSj to each macro common test pattern in accordance with the type number of a product. That is, as shown in Fig. 5C, the product parameters typically vary in terms of:
allocated terminal (TDi); and
address of a macro (MSj).

Reference numeral 14 designates an operating section such as a keyboard. The operation inputs a series name of a CPU and a name of a product to be retrieved by way of the operating section 14.

Reference numeral 15 designates a test pattern converter. The test pattern converter 15 reads conversion data from the CPU series conversion library 12 in accordance with a specific CPU series input by the operator by way of the operating section 14 and also reads conversion data from the product parameter file 13 input by the operator by way of the operating section 14. Then, the test pattern converter 15 reads a macro common test pattern from the macro common test pattern file 11 and converts it into the macro common test pattern by the above-mentioned conversion data. For example, if the series name of a CPU is CPUA, the number of bits is 32 bits. Also, if the product name is MACR01, the number of bits of the test data terminal is 8 bits.

Thus, the test pattern converter 15 generates a plurality of product macro test patterns including "MASK"/"CARE" information such as FF0_{H}, FF1_{H}, ···, 00A_{H} and 06B_{H} for each macro common test pattern formed by 5500_{H}, 0B_{H} and 06_{H}, for example, Then, the product macro test patterns are written into a product macro test pattern life 16.

The product macro test patterns stored in the product macro test pattern file 16 are supplied by a test pattern generator 17 to the peripheral macros of the one-chip microcomputers 2-1, 2-2 and 2-3, thus sequentially performing test operations upon the peripheral macros.

In Fig. 1, although the macro common test pattern file 11, the CPU series conversion library 12, the product parameter file 13 and the product macro test pattern file 16 are illustrated as independent memories in Fig. 1, they may be replaced by a single memory that can store all the data.

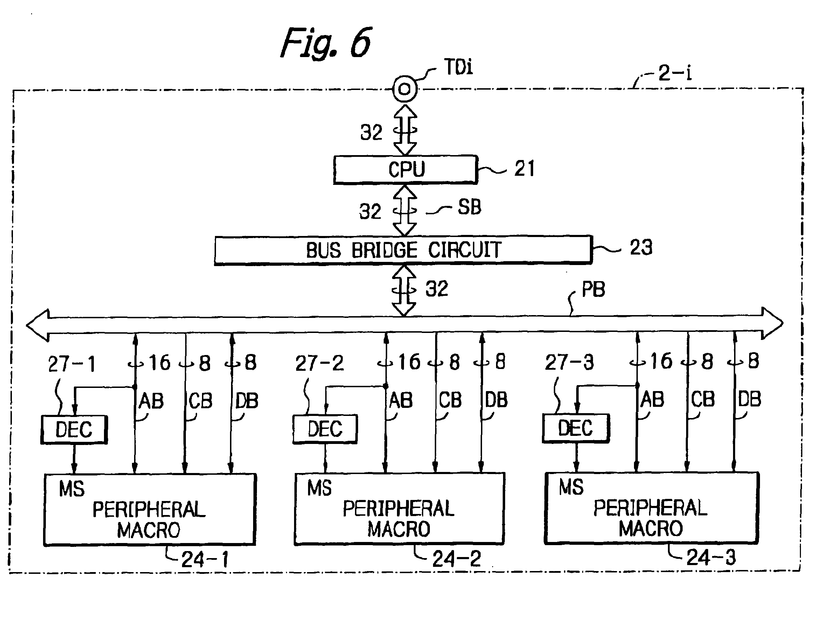

In Fig. 6, which illustrates a first modification of the one-chip microcomputer of Fig. 2, the test data terminal TDi and the test circuit 22 of Fig. 2 are not provided. Then, the peripheral macros 24-1, 24-2 and 24-3 are tested directly by way of the CPU 21 depending on the type of the product. The test apparatus of Fig. 1 can also be applied to the one-chip microcomputer of Fig. 6. In this case, the macro common test patterns of the macro common test pattern file 11 are represented by an assembler code of the CPU 21, so that the test pattern converter 15 converts the program in accordance with the CPU series conversion library 12 and the product parameter file 13 and generates product macro test patterns.

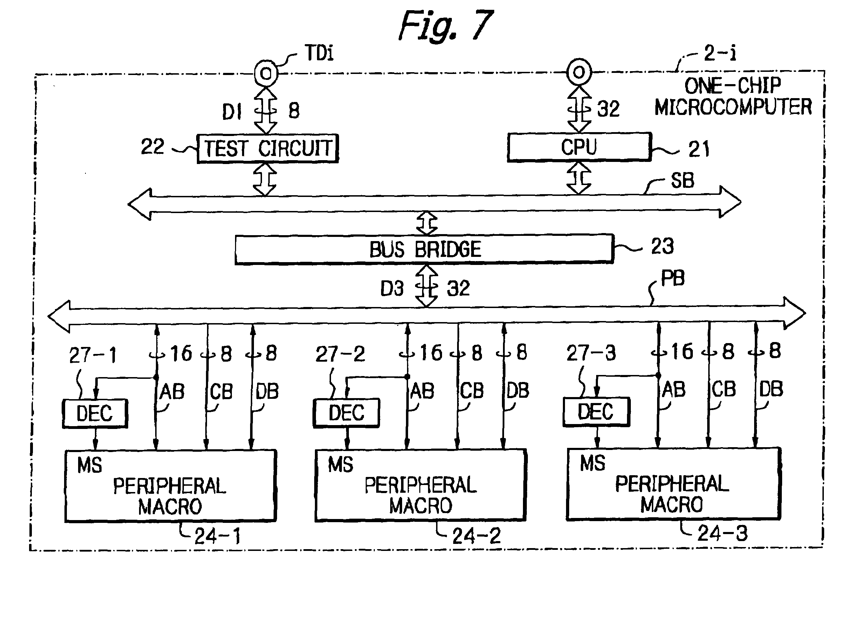

In Fig. 7, which illustrates a second modification of the one-chip microcomputer of Fig. 2, the output terminal of the test circuit 22 is connected to the system bus SB of the CPU 21, and macro common test patterns can be generated by the test apparatus of Fig. 1. In this case, macro common test patterns are patterns capable of being supplied to the system bus SB for the purpose of testing, so that the test pattern converter 15 of Fig. 1 converts these patterns in accordance with the CPU series conversion library and the product parameter file to generate product macro test patterns.

Additionally, as illustrated in Fig. 8, which illustrates a third modification of the one-chip microcomputer of Fig. 2, there may be products (peripheral macros) in which each of the peripheral macros 24-1, 24-2 and 24-3 has test input terminals TI and test output terminals T0, and the input terminals TI are commonly connected to external test input terminals GI1 and GI2 while the output terminals T0 are commonly connected to external test output terminals G01 and G02. In this case, the macro common test patterns includes test data to be supplied to the external test input terminals GI1 and GI2, and the timing of supplying the test data to the external test input terminals GI1 and GI2 is converted by using the CPU series conversion library 12 and the product parameter file 13.

In the above-described embodiment, although the one-chip microcomputer is equipped with the CPU 2, the present invention is also applicable to a semiconductor device not equipped with a CPU.

As explained hereinabove, according to the present invention, since a data conversion library corresponding to the characteristics of the control circuit, i.e., the CPU is prepared in advance and macro common test patterns are converted into product macro test patterns by referring to the library, it is no longer necessary to prepare a test pattern for each CPU series. As a result, the work load and the time required for preparing the test pattern can be greatly reduced.

Additionally, the differences among products to be tested do not need to be taken into consideration if a product test pattern is prepared by referring to a functional parameter specific to each product. As a result, the efficiency of generation of test patterns can be further enhanced.

## Claims

1. A method for generating a test pattern for testing at least one circuit block (24-1, 24-2, 24-3) of a semiconductor device including a control circuit (21) connected to said circuit block, said method comprising a step of generating said test pattern by converting a common test pattern (11) for said circuit block with reference to a data conversion library (12) corresponding to characteristics of said control circuit.

2. The method as set forth in claim 1, wherein the characteristics of said control circuit include a number of bits, instruction codes and a signal sequence.

3. The method as set forth in claim 1, wherein said semiconductor device comprises:
a peripheral bus (PB) connected between said control block and said control circuit;
a test data terminal (TDi); and
a test circuit (22) connected between said test data terminal and said peripheral bus.

4. The method as set forth in claim 3, wherein said common test pattern is specifically adapted to said peripheral bus,
said common test pattern being converted into said test pattern with reference to a number of bits of said test data terminal.

5. The method as set forth in claim 3, wherein said common test pattern is specifically adapted to said peripheral bus,
said common test pattern being converted into said test pattern with reference to a functional parameter of said circuit block.

6. The method as set forth in claim 5, wherein an address component of said common test pattern is converted into an address specific to said circuit block.

7. The method as set forth in claim 5, wherein a terminal component of said common test pattern is converted into a terminal component (MSj) specific to said circuit block.

8. The method as set forth in claim 1, wherein said semiconductor device comprises a one-chip microcomputer, said control circuit comprising a central processing unit.

9. An apparatus for generating a test pattern for testing at least one circuit block (24-1, 24-2, 24-3) of a semiconductor device including a control circuit (21) connected to said circuit block comprising:
a common test pattern file (11) for storing common test patterns for said circuit block;
a data conversion library (12) for storing characteristics of said control circuit; and
a test pattern converter (15), connected to said common test pattern file and said data conversion library, for generating said test pattern by converting one of said common test patterns with reference to the characteristics of said control circuit.

10. The apparatus as set forth in claim 9, wherein the characteristics of said control circuit include a number of bits, instruction codes and a signal sequence.

11. The apparatus as set forth in claim 9, wherein said semiconductor device comprises:
a peripheral bus (PB) connected between said control block and said control circuit;
a test data terminal (TDi); and
a test circuit (22) connected between said test data terminal and said peripheral bus.

12. The apparatus as set forth in claim 11, wherein said common test pattern is specifically adapted to said peripheral bus,
said one of said common test patterns being converted into said test pattern with reference to a number of bits of said test data terminal.

13. The apparatus as set forth in claim 11, wherein said one of said common test patterns is specifically adapted to said peripheral bus,
said apparatus further comprising a product parameter file (13) for storing a functional parameter for said circuit block, so that said one of said common test patterns is converted into said test pattern with reference to the functional parameter of said circuit block.

14. The apparatus as set forth in claim 13, wherein the functional parameter of said circuit block includes an address specific to said circuit block, so that an address component of said one of said common test patterns is converted into the address specific to said circuit block.

15. The apparatus as set forth in claim 13, wherein the functional parameter of said circuit block includes a terminal component (MSj) specific to said circuit block, so that a terminal component of said one of said common test patterns is converted into the terminal component specific to said circuit block.

16. The apparatus as set forth in claim 9, wherein said semiconductor device comprises a one-chip microcomputer, said control circuit comprising a central processing unit.

17. The apparatus as set forth in claim 9, wherein said common test pattern file and said data conversion library comprise a single memory.

18. The apparatus as set forth in claim 13, wherein said common test pattern file, said data conversion library and said product parameter file comprise a single memory.
